(19) 

Europäisches
Patentamt
European
Patent Office
Office européen
des brevets

(11) **EP 3 196 766 A1**

(12) **EUROPEAN PATENT APPLICATION**

(43) Date of publication:
26.07.2017 Bulletin 2017/30

(51) Int Cl.:
*G06F 11/36* (2006.01)

(21) Application number: 17151644.6

(22) Date of filing: 16.01.2017

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **19.01.2016 US 201615000684**

(71) Applicant: **Siemens Industry Software NV
3001 Leuven (BE)**

(72) Inventors:
• **FURIC, Sebastien
56560 Gwiskri
Brittany (FR)**
• **NEUHÄUSSER, Martin Richard
90461 Nürnberg (DE)**
• **RICHTER, Jan
91207 Lauf a.d. Pegnitz (DE)**

(74) Representative: **Maier, Daniel Oliver
Siemens AG
Postfach 22 16 34
80506 München (DE)**

(54) **INITIALIZATION OF HYBRID EQUATION-BASED DYNAMICAL SYSTEM MODELS USING SMT METHODS**

(57) A SMT method for initialization of a hybrid equation-based dynamic system representing a dynamic behavior of a physical device, said method comprising: preparing a SMT problem, solving the SMT problem using a SMT solver, extracting a plurality of unfixed start value premises from UNSAT cores, creating a relaxed SMT problem by removing the plurality of unfixed start value premises, solving the relaxed SMT problem using the SMT solver, extracting the solution from the SMT solver and considering further algorithms to solve the relaxed SMT problem.

FIG 1

EP 3 196 766 A1

## Description

FIELD Of the invention

The present application refers to methods and systems for initialization of hybrid equation-based dynamical system models using Satisfiability Modulo Theory (SMT) methods and more particularly a dynamical system modeled on a computer system.

BACKGROUND OF THE INVENTION

The present invention relates to a method creating valid initial conditions for the mathematical formal models of physical systems like engines, electrical circuits, or the like.

The behavior of many physical systems e.g. gears, engines, electrical circuits can be described with differential equations. These behavioral models are implemented in computer systems. In order to simulate the behavior of a physical system from a start time point a collection of consistent initial conditions for the behavioral model is needed.

The behavior of physical system are normally modeled or implemented in computer systems. Computer Programs like Modelica rely on the usage of Differential Algebraic Equations (DAE) to model a dynamic behavior of a physical system. DAEs not only include equations describing the behavior of the physical system, but also include equations which specify the constraint placed on the operation condition of the physical system. These are normally described in the form of algebraic equations. For many physical systems, in reality, these constraint equations are nonlinear. In physics and other sciences, a nonlinear system, in contrast to a linear system, is a system which does not satisfy the superposition principle. Superposition means that if any two solutions (groups of inputs, states, outputs and variables) taken, their scaled sum is also a solution.

To find initial conditions for such physical systems modeled in the form of a DAE in a computer environment, numerical or symbolic methods are used. Each of these methods used to find out the initial conditions show disadvantages in practice, e.g. using numerical method might find a local minimum rather a global minimum, and symbolic methods are complex to use and may provide unreliable results.

It is desirable and advantageous to improve the methods of initializing behavioral models of physical systems modeled in a computer environment.

The following discussion of related art is provided to assist the reader in understanding the advantages of the invention, and is not to be construed as an admission that this related art is prior art to this invention.

SUMMARY OF THE INVENTION

The present invention is directed to a SMT method for initialization of a hybrid equation-based dynamic system representing a dynamic behavior of a physical device, said method comprising: preparing a SMT problem, solving the SMT problem using a SMT solver, extracting a plurality of unfixed start value premises from unsatisfiable (UNSAT) cores, creating a relaxed SMT problem by removing the plurality of unfixed start value premises, solving the relaxed SMT problem using the SMT solver, extracting the solution from the SMT solver and considering further algorithms to solve the relaxed SMT problem.

According to an advantageous embodiment of the invention the SMT method further comprises determining if a fixed start value premise exist in UNSAT cores of the relaxed SMT problem, creating a relaxed SMT problem by removing the fixed start value premise from the relaxed SMT problem, solving the relaxed SMT problem using a SMT solver, extracting the solution from the SMT solver, determining if a constraint equation exist in UNSAT cores of the relaxed SMT problem, creating a relaxed SMT problem by removing the constraint equation from the relaxed SMT problem, solving the relaxed SMT problem using the SMT solver, and extracting the solution from the SMT solver.

Various objects, features, aspects, and advantages of the present invention will become more apparent from the following detailed description of preferred embodiments of the invention, along with the accompanying drawings in which like numerals represent like components.

BRIEF DESCRIPTION OF THE DRAWING

Other features and advantages of the present invention will be more readily apparent upon reading the following description of currently preferred exemplified embodiments of the invention with reference to the accompanying drawing, in which:

FIG. 1 is a flowchart for process flow illustrating a basic method of initializing a hybrid equation-based dynamic system,

FIG. 2 is a flowchart for process flow illustrating an automatically relaxing method of initializing a hybrid equation-based dynamic system; and

FIG. 3 is a flowchart for process flow illustrating an interactively relaxing method of initializing a hybrid equation-based dynamic system.

DETAILED DESCRIPTION OF PREFERRED EMBODIMENTS

Throughout all the figures, same or corresponding elements may generally be indicated by same reference numerals. These depicted embodiments are to be understood as illustrative of the invention and not as limiting in any way. It should also be understood that the embodiments are sometimes illustrated by graphic symbols, phantom lines, diagrammatic representations and fragmentary views. In certain instances, details which are not necessary for an understanding of the present invention or which render other details difficult to perceive may have been omitted.

Mathematical models of physical systems or components are used in different engineering fields in order to analyze, design, simulate or even implement a component or system. Examples of systems or components to be modeled are a pendulum, an engine, an electrical circuit, or the like. Most of the physical systems are mathematically modeled in form of differential equations. For example a simple system might be modeled as an Ordinary Differential Equation (ODE). An ODE is a mathematical equation which describes the relationship between an independent variable (usually time) and a set of dependent variables and the derivatives with respect to the independent variable. The solution of the ODE depends on the initial condition and the constraints placed on the equation. The set of initial values, and the constraints specify how the ODE will evolve with time.

Considering the complexity of mathematical models of physical system, computer systems are normally used in order to analyze, design, simulate or implement a system using mathematical models. A differential equations used for modeling a physical system in a computer system is normally specified as a Differential Algebraic Equation or DAE. The DAEs are a general form of systems of differential equations for vector-based functions. For example a DAE system example described below consists of a pair (x,y) of vectors of dependent variables and one independent variable t for time. A DAE system may be explicit, semi-explicit or implicit.

$$\dot{x}(t) = f(x(t), y(t), t),$$

$$0 = g(x(t), y(t), t).$$

Where $\quad x(t) \in \mathbb{R}^n, \quad y(t) \in \mathbb{R}^m,$

$f : \mathbb{R}^{n+m+1} \to \mathbb{R}^n \qquad$ and

$g : \mathbb{R}^{n+m+1} \to \mathbb{R}^m.$

The differential function *f* in the DAE system example describes the dynamic behavior of the physical system and the function g normally called a constraint equation (CE) is an algebraic function free of derivatives. The constraint equation *g* of the DAE system example shall be satisfied during the all times during the simulation of the physical system. Optionally a DAE system may include other constraint function(s) which apply only during the initialization.

In order to simulate or execute a DAE system on a computer system an initialization point for the independent variable is necessary, e.g. time point $t_0$. All variables of a DAE system and their derivatives do need to have valid initialization values for the start point $t_0$. This is a prerequisite in order to be able to start a simulation from the start point to onward. Furthermore an admissible initial value must satisfy the constraint equations at the start point $t_0$.

There are various methods known to be used for determining a set of initialization values for a DAE system. Generally these methods can be categorized in two groups:

I) numerical methods: In this method the initialization problem is formulated as an optimization problem and the initialization values can be determined by finding the global minimum of the optimization function. However this method might find a local minimum of the optimization function rather than the global minimum. A local minimum of a function is a point where the function value is smaller than at nearby points, but possibly greater than at a distant point. A global minimum is a point where the function value is smaller than at all other feasible points in the entire interval. A local minimum may not be the optimal solution for the ODE for the entire interval. A local minimum may not represent a consistent initial value, since g(x (t),y(t),t) may be small from a numerical point of view, but not zero. Furthermore if the DAE system includes discrete variables an optimization method to calculate the initial values might not work properly. Regarding the disadvantages of numerical methods for initial values calculations refer to [1], [2], [7], [8].

II) Symbolic method: In this method the algebraic constraint equation is turned to an assignment problem. An assignment problem reduces a DAE to a set of combination logic with the aim to find a set of weighting function such that the sum of the product is the global minimum. The optimization problem treats a DAE as a continuous system and the system moves to the global minimum. There are multiple disadvantages in using this method. For example these can be referred to in the references [5] and [6].

In practice many DAE systems differential equations and constrain equations include linear and non-linear real arithmetic, integer arithmetic, Boolean statements and conditional statements which may connect Boolean with arithmetic statements in a so called hybrid system. The goal is to find initial values for the variables and the derivatives used in the DAE so that all differential equations, constraint equations including the constraint which apply during initialization and constraints which apply for all times are all satisfied at start point $t_0$.

According to a method disclosed in this application Satisfiability Modulo Theory can be used to establish an improved method of finding initial values for a DAE system modeled and simulated in a computer system. In computer science and mathematical logic, the satisfiability modulo theories (SMT) problem is a decision problem for logical formulas with respect to combinations of background theories expressed in classical first-order logic with equality. The most well-known constraint satisfaction problem is propositional satisfiability, or SAT, aiming to decide whether a formula over Boolean variables, formed using logical connectives, can be made true by choosing true/false values for its variables. Some problems are more naturally described with richer languages (such as arithmetic). A supporting theory (of arithmetic) is then required to capture the meaning of the formulas. Solvers for such formulations are commonly called "satisfiability modulo theories," solvers or SMT solvers. There are various SMT solvers available e.g. Z3 or MathSAT. At the heart of a SMT solver is a framework for tracking truth values for logical prepositions as well as formulas. Additionally SMT solvers use a method called lemma learning which enables SMT solver to memorize the results of searches as new knowledge at logical level. In other words, SMT solvers try to find a combination of true/false values for logical prepositions which satisfy the whole set of prepositions of an SMT model. This feature memorizes the combinations which do not satisfy in order to converge possibly toward a satisfying result.

According to a method for initialization of hybrid equation-based an initialization problem is formulated and interpreted as a SMT problem. An SMT problem created according to the method disclosed will be satisfied only with the valid initialization values for the variables and derivatives of the variables used on the DAE model of the physical system under consideration. A SMT solver is then utilized to search for satisfying results. Various SMT solvers are available both as free open source ones and commercial proprietary variants. When a SMT solver is unable to find satisfying conditions for a SMT problem it returns a set of so called UNSAT cores. In mathematical logic, given an unsatisfiable Boolean propositional formula in conjunctive normal form, a subset of clauses whose conjunction is unsatisfiable is called an unsatisfiable core (UNSAT core) of the original formula. A returned set of UNSAT cores from a SMT solver is used in the disclosed method to find a way to satisfy the SMT problem and extract a valid initial condition.

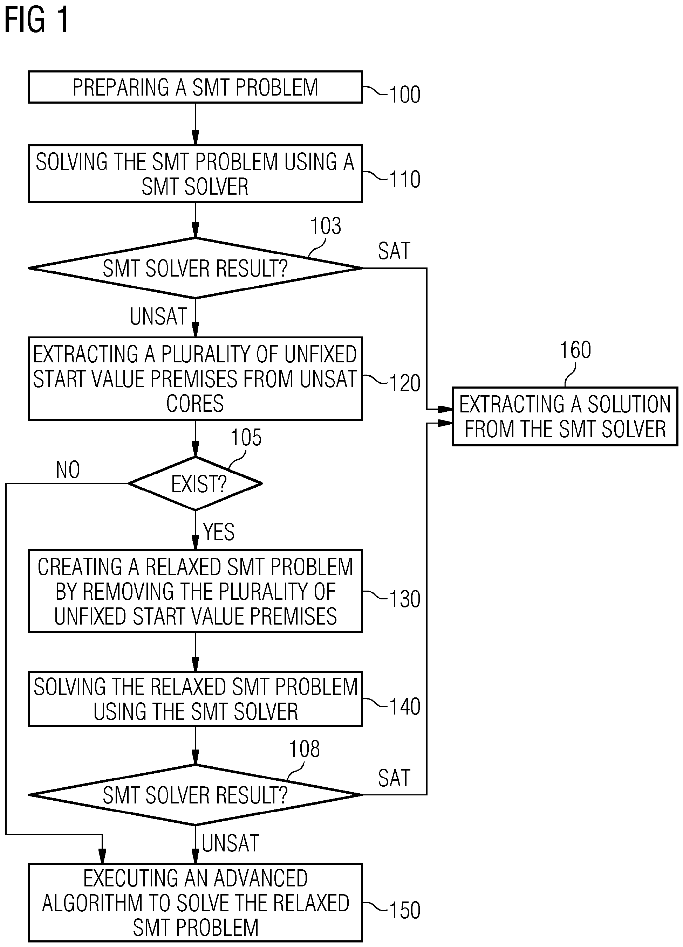

Turning now to the drawing, and in particular to Fig. 1 there is shown a process flowchart illustrating a basic method for initialization of a hybrid equation-based dynamic system from here on referred to as the basic method. The basic method comprises the following steps:

Preparing a SMT problem (100): In this step all describing information for a hybrid equation-based dynamic system including differential equations, initial equations, constraint equations, and start values premises are collected to be formed as a SMT problem. Optionally variables are also qualified by range information, i.e. by minimum and maximum which define the boundaries for model validity. These are then formulated in form of a SMT problem so as a satisfying condition for the SMT problem will provide the initial condition of the hybrid equation-based dynamic system. This step further comprised tagging each start value with either "fixed" or "unfixed" flag. An "unfixed" flag indicates that a start value is just a guess. A "fixed" tag for a start value indicates that a user is convinced the start value is proper.

In accordance to a feature of the invention a start value in the SMT problem has a type which may be real, Boolean or integer. For example a start value premise from the type real can be formulated as: $x(t_0)= x_0$, $x_0 \in R$.

Solving the SMT problem using a SMT solver (110): A SMT solver for example Z3 is used to find a satisfying condition for the SMT problem.

Extracting a plurality of unfixed start value premises from UNSAT cores (120): if the SMT problem solved in step 110 is UNSAT, then a returned set of UNSAT cores from the SMT solver is analyzed to find all start value premises which are included in the UNSAT cores and are flagged as "unfixed", i.e. these values are guess values provided by the user.

Creating a relaxed SMT problem by removing the plurality of unfixed start value premises (130): if the plurality of unfixed start value premises from UNSAT cores is not empty, then the step 130 is executed. In step 130 the plurality of unfixed start value premises from UNSAT cores is removed from the SMT problem, with that a new SMT problem is created a so called relaxed SMT problem because by removing premises the restrictions get relaxed.

Solving the relaxed SMT problem using the SMT solver (140): The SMT solver is utilized to solve the relaxed SMT problem. After removing the plurality of unfixed start value premises in step 130, it is expected that a satisfying solution is found by the SMT solver.

Executing an advanced algorithm to solve the relaxed SMT problem (150): if the relaxed SMT problem is unsatisfied this algorithm is unable to find a satisfying solution. Further algorithms as disclosed in the following can be used to find a solution for the problem.

Extracting a solution from the SMT solver (160): if the relaxed SMT problem is satisfiable, the satisfying solution found by the SMT solver is then used to extract the initial condition for the hybrid equation-based dynamic problem which was used in step 100 to create the SMT problem.

According to a feature of the invention the SMT problem can be modeled in Modelica. However a use of other software languages like Spice or the like is possible.

In most cases the describing information provided in step 100 e.g. start value premises are inconsistent. An advantage of using SMT method is that the SMT solver provided a minimal set of UNSAT cores. For example the SMT solver may provide a minimal set of premises that cause the inconsistency. An inconsistency can have multiple root causes for example: I) wrong start values lead to contradiction together or with constraint equations, or II) the model equations are contradictory.

When the basic method fails to find a satisfactory solution according to step 150, further algorithms can be utilized. Two methods may be utilized to solve the SMT problem: I) an automatically relaxing method of initializing a hybrid equation-based dynamic system, from here on referred to as the automatically relaxing method, or II) an interactively relaxing method of initializing a hybrid equation-based dynamic system from here on referred to as the interactively relaxing method.

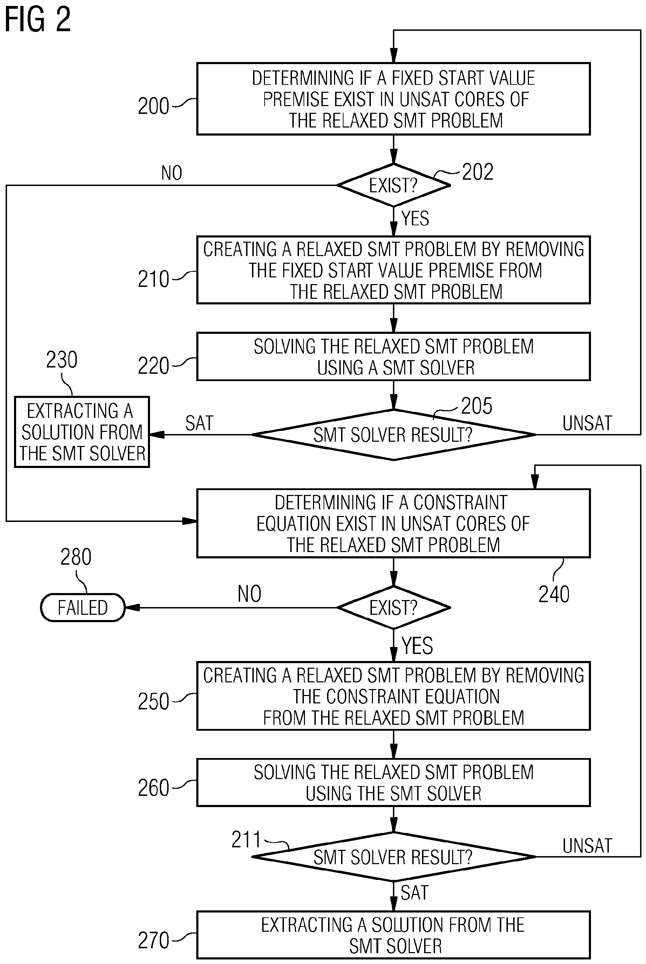

According to the drawing and in particular Fig. 2 there is shown a process flowchart illustrating the automatically relaxing method. The automatically relaxing method comprises the following steps:

> Determining if a fixed start value premise exist in UNSAT cores of the relaxed SMT problem (200): In this step a search is conducted among UNSAT cores to determine if a start value premise exist which is flagged as "fixed".

Creating a relaxed SMT problem by removing the fixed start value premise from the relaxed SMT problem (210): The fixed start value premise taken in step 200 is removed from the relaxed SMT problem and a relaxed SMT problem is created. In this procedure the relaxed SMT problem is replaced similar to assignments statements like A=A-1 which replaces the value of A with the value of A-1. After this step the relaxed SMT problem is more relaxed than before because a fixed start value premise is removed. Preferably a start value premise should be removed to relax the SMT problem rather than a constraint equation, because removing a constraint equation from the SMT problem may have an impact on the behavior of the hybrid system. Here it should be considered that it is more likely that a user had false confidence in the chosen start values, rather than selecting false equations in the model.

Solving the relaxed SMT problem using a SMT solver (220): The SMT solver is utilized to solve the relaxed SMT problem. After removing the "fixed" start value premise in step 210, it is expected that a satisfying solution is found by the SMT solver.

Extracting a solution from the SMT solver (230): if in the 220 the SMT solver is able to find a satisfying solution for the SMT solver then in this step the satisfying solution found by the SMT solver is used to extract the initial condition for the hybrid equation-based dynamic problem.

Responsive to the SMT solver being unsatisfied after step 220 the step 200 will be executed again. This keeps removing "fixed" start value premises from the relaxed SMT problem until no other "fixed" start value premise left in the relaxed SMT problem. In that case it will proceed to step 240.

Determining if a constraint equation exists in UNSAT cores of the relaxed SMT problem (240): In this step a search is conducted among UNSAT cores to determine if a constraint equation exists among UNSAT cores of the relaxed SMT problem.

Creating a relaxed SMT problem by removing the constraint equation from the relaxed SMT problem (250): The fixed start value premise taken in step 240 is removed from the relaxed SMT problem and a relaxed SMT problem created. This step is taken after the possibility of removing start value premises is fully utilized in the prior steps of the automatically relaxing method.

Solving the relaxed SMT problem using the SMT solver (260): The SMT solver is utilized to solve the relaxed SMT problem. After removing the constraint equation start value premise in step 210, it is expected that a satisfying solution is found by the SMT solver.

Extracting a solution from the SMT solver (270): if the relaxed SMT problem is satisfiable, the satisfying solution found by the SMT solver is then used to extract the initial condition for the hybrid equation-based dynamic problem.

Responsive to the SMT solver being unsatisfied after step 260 the step 240 will be executed again. This keeps removing constraint equations from the relaxed SMT problem until no constraint equation is left in the relaxed SMT problem. In that case it will proceed to Failed (280), i.e. the algorithm is inoperable to find an initial condition for the SMT problem.

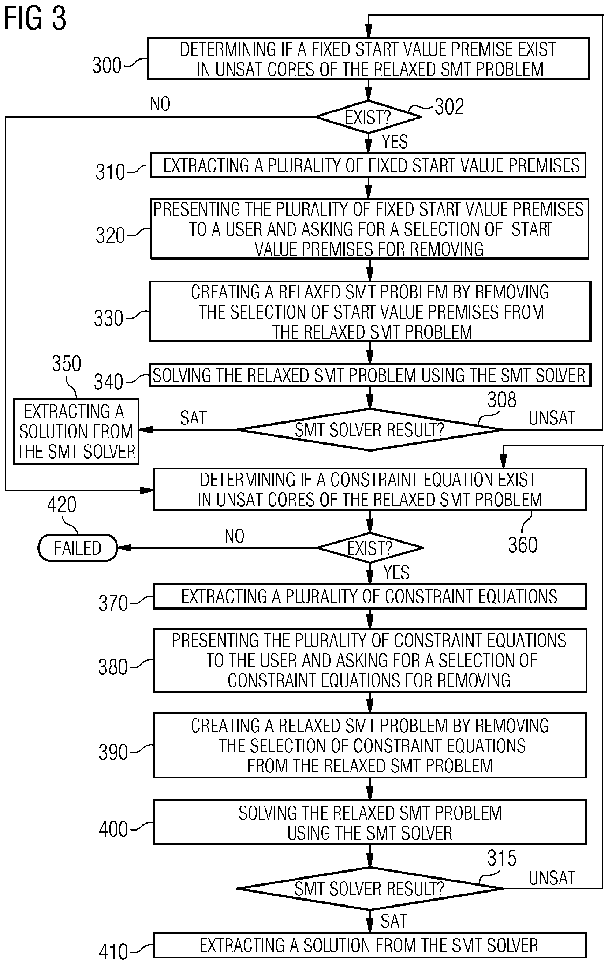

According to the drawing and in particular Fig. 3 there is shown a process flowchart illustrating the interactively relaxing method. This method includes interaction with a user. A user could be a human or could be another algorithm or method, e.g. an artificially intelligent software agent which makes a decision. The interactively relaxing method comprises the following steps:

> Determining if a fixed start value premise exist in UNSAT cores of the relaxed SMT problem (300): In this step a search is conducted among UNSAT cores to determine if a start value premise exists which is flagged as "fixed".

Extracting a plurality of fixed start value premises (310): if a start value premise flagged as "fixed" was found in step 300, then a plurality of all "fixed" start value premises is extracted from the relaxed SMT problem.

Presenting the plurality of fixed start value premises to a user and asking for a selection of start value premises for removing (320): The plurality of all start value premises extracted in the step 300 is presented to a user. The user shall make a selection of one or more start value premises to be removed.

Creating a relaxed SMT problem by applying the selection of start value premises from the relaxed SMT problem (330): the selection made by the user at step 320 to be removed from the relaxed SMT problem and create a relaxed SMT problem.

Solving the relaxed SMT problem using the SMT solver (340): The SMT solver is utilized to solve the relaxed SMT problem.

Extracting a solution from the SMT solver (350): if the relaxed SMT problem is satisfiable, the satisfying solution found by the SMT solver is then used to extract the initial condition for the hybrid equation-based dynamic problem. If the relaxed SMT problem is UNSAT the step 300 will be executed again.

Determining if a constraint equation exist in UNSAT cores of the relaxed SMT problem (360): In this step a search is conducted among UNSAT cores to determine if a constraint equation exists among UNSAT cores of the relaxed SMT problem. This step is executed only if after executing the step 300 it is determined that no fixed start value premise exist in UNSAT cores of the relaxed SMT problem.

Extracting a plurality of constraint equations (370): if a constraint equation was found in step 360, then a plurality of all constraint equations is extracted from the relaxed SMT problem. If no constraint found then the interactively relaxing method is inoperable to find an initial condition for the SMT problem and will proceed to Failed (420).

Presenting the plurality of constraint equations to the user and asking for a selection of constraint equations for removing (380): The plurality of constraint equation extracted in step 370 is presented to a user. The user shall make a selection of one or more start value premises to be removed.

Creating a relaxed SMT problem by removing the selection of constraint equations from the relaxed SMT problem (390): The selection made by the user at step 380 to be removed from the relaxed SMT problem and create a relaxed SMT problem.

Solving the relaxed SMT problem using the SMT solver (400): The SMT solver is utilized to solve the relaxed SMT problem.

Extracting the solution from the SMT solver (410): if the relaxed SMT problem is satisfiable, the satisfying solution found by the SMT solver is then used to extract the initial condition for the hybrid equation-based dynamic problem. If the relaxed SMT problem is UNSAT then step 360 will be executed again.

The SMT method is based on symbolic language concept. A symbolic language manipulates predefined symbols to solve the mathematical equations. A symbolic language includes a vocabulary of mathematical symbols and a set of predefined rules to manipulate these symbols. The set of equations and initial conditions and constraints are presented in a SMT problem as a set of symbols - mathematical equations presented as symbolic strings which follow the predefined rules. A solution of a SMT problem will be presented also in the symbolic language.

According to a feature of the methods disclosed, non-linear real arithmetic symbolic clauses are used in a SMT problem. The results will be exact and symbolic which will prevent the usual numerical methods truncation error. Different computer systems based on software capabilities and the way of handling variables will give different results in a numerical calculation, for example a symbolic result will provide a value as 2/3. This will avoid any truncation error. It is up to a user to decide how to calculate the division and how many decimal points to be used in the calculation.

According to another aspect of the invention a computer system for initializing a hybrid equation-based dynamic system comprising a processor and computer readable code implementing the basic method.

According to another aspect of the invention an enhanced computer system for initializing a hybrid equation-based dynamic system comprising a processor and computer readable code implementing the basic method and the automatically relaxing method.

According to another aspect of the invention an enhanced computer system with interactive feature for initializing a hybrid equation-based dynamic system comprising a processor and computer readable code implementing the basic method and the interactively relaxing method.

While the invention has been illustrated and described in connection with currently preferred embodiments shown and described in detail, it is not intended to be limited to the details shown since various modifications and structural changes may be made without departing in any way from the spirit and scope of the present invention. The embodiments were chosen and described in order to explain the principles of the invention and practical application to thereby enable a person skilled in the art to best utilize the invention and various embodiments with various modifications as are suited to the particular use contemplated.

What is claimed as new and desired to be protected by Letters Patent is set forth in the appended claims and includes equivalents of the elements recited therein.

**Claims**

1. A SMT method for initialization of a hybrid equation-based dynamic system representing a dynamic behavior of a physical device, the SMT method comprising:

   preparing a SMT problem;
   solving the SMT problem using a SMT solver;
   extracting a plurality of unfixed start value premises from UNSAT cores;
   creating a relaxed SMT problem by removing the plurality of unfixed start value premises;
solving the relaxed SMT problem using the SMT solver;
extracting a solution from the SMT solver; and executing an advanced algorithm to solve the relaxed SMT problem.

2. The SMT method of claim 1, wherein the advanced algorithm further comprises:

determining if a fixed start value premise exist in UNSAT cores of the relaxed SMT problem;
creating a relaxed SMT problem by removing the fixed start value premise from the relaxed SMT problem;
solving the relaxed SMT problem using a SMT solver;
extracting a solution from the SMT solver;
determining if a constraint equation exist in UNSAT cores of the relaxed SMT problem;
creating a relaxed SMT problem by removing the constraint equation from the relaxed SMT problem;
solving the relaxed SMT problem using the SMT solver;
and
extracting the solution from the SMT solver.

3. The SMT method of claim 1, wherein the advanced algorithm further comprises:

determining if a fixed start value premise exist in UNSAT cores of the relaxed SMT problem;
extracting a plurality of fixed start value premises;
presenting the plurality of fixed start value premises to a user and asking for a selection of start value premises for removing;
creating a relaxed SMT problem by removing the selection of start value premises from the relaxed SMT problem;
solving the relaxed SMT problem using a SMT solver;
extracting a solution from the SMT solver;
determining if a constraint equation exist in UNSAT cores of the relaxed SMT problem;
extracting a plurality of constraint equations;
presenting the plurality of constraint equations to the user and asking for a selection of constraint equations for removing;
creating a relaxed SMT problem by removing the selection of constraint equations from the relaxed SMT problem; and
solving the relaxed SMT problem using the SMT solver.

4. The SMT method of claim 1, wherein the SMT solver is Z3.

5. The SMT method of claim 1, wherein the SMT problem is modeled in Modelica.

6. The SMT method of claim 1, wherein a start value has a type selected from the group consisting of real, Boolean and integer.

7. The SMT method of claim 1, wherein the SMT problem further comprises non-linear real arithmetic symbolic clauses.

8. A computer system for initializing a hybrid equation-based dynamic system comprising a processor and computer readable code implementing the SMT method of claim 1.

9. A computer system for initializing a hybrid equation-based dynamic system comprising a processor and computer readable code implementing the SMT method of claim 2.

# FIG 1

PREPARING A SMT PROBLEM — 100

SOLVING THE SMT PROBLEM USING A SMT SOLVER — 110

SMT SOLVER RESULT? — 103

SAT

UNSAT

EXTRACTING A PLURALITY OF UNFIXED START VALUE PREMISES FROM UNSAT CORES — 120

160

EXTRACTING A SOLUTION FROM THE SMT SOLVER

EXIST? — 105

NO

YES

CREATING A RELAXED SMT PROBLEM BY REMOVING THE PLURALITY OF UNFIXED START VALUE PREMISES — 130

SOLVING THE RELAXED SMT PROBLEM USING THE SMT SOLVER — 140

SMT SOLVER RESULT? — 108

SAT

UNSAT

EXECUTING AN ADVANCED ALGORITHM TO SOLVE THE RELAXED SMT PROBLEM — 150

# FIG 2

200 — DETERMINING IF A FIXED START VALUE
PREMISE EXIST IN UNSAT CORES OF
THE RELAXED SMT PROBLEM

202
EXIST?

NO

YES

210 — CREATING A RELAXED SMT PROBLEM BY REMOVING
THE FIXED START VALUE PREMISE FROM
THE RELAXED SMT PROBLEM

220 — SOLVING THE RELAXED SMT PROBLEM
USING A SMT SOLVER

230

EXTRACTING A
SOLUTION FROM
THE SMT SOLVER

SAT

205
SMT SOLVER RESULT?

UNSAT

DETERMINING IF A CONSTRAINT
EQUATION EXIST IN UNSAT CORES OF
THE RELAXED SMT PROBLEM

240

280

FAILED

NO

EXIST?

YES

250 — CREATING A RELAXED SMT PROBLEM BY REMOVING
THE CONSTRAINT EQUATION
FROM THE RELAXED SMT PROBLEM

260 — SOLVING THE RELAXED SMT PROBLEM
USING THE SMT SOLVER

211
SMT SOLVER RESULT?

UNSAT

SAT

270 — EXTRACTING A SOLUTION FROM THE
SMT SOLVER

# FIG 3

300 — DETERMINING IF A FIXED START VALUE PREMISE EXIST IN UNSAT CORES OF THE RELAXED SMT PROBLEM

302 — EXIST? — NO / YES

310 — EXTRACTING A PLURALITY OF FIXED START VALUE PREMISES

320 — PRESENTING THE PLURALITY OF FIXED START VALUE PREMISES TO A USER AND ASKING FOR A SELECTION OF START VALUE PREMISES FOR REMOVING

330 — CREATING A RELAXED SMT PROBLEM BY REMOVING THE SELECTION OF START VALUE PREMISES FROM THE RELAXED SMT PROBLEM

340 — SOLVING THE RELAXED SMT PROBLEM USING THE SMT SOLVER

350 — EXTRACTING A SOLUTION FROM THE SMT SOLVER

308 — SMT SOLVER RESULT? — SAT / UNSAT

360 — DETERMINING IF A CONSTRAINT EQUATION EXIST IN UNSAT CORES OF THE RELAXED SMT PROBLEM

420 — FAILED — NO / EXIST? / YES

370 — EXTRACTING A PLURALITY OF CONSTRAINT EQUATIONS

380 — PRESENTING THE PLURALITY OF CONSTRAINT EQUATIONS TO THE USER AND ASKING FOR A SELECTION OF CONSTRAINT EQUATIONS FOR REMOVING

390 — CREATING A RELAXED SMT PROBLEM BY REMOVING THE SELECTION OF CONSTRAINT EQUATIONS FROM THE RELAXED SMT PROBLEM

400 — SOLVING THE RELAXED SMT PROBLEM USING THE SMT SOLVER

315 — SMT SOLVER RESULT? — UNSAT / SAT

410 — EXTRACTING A SOLUTION FROM THE SMT SOLVER

Europäisches
Patentamt

European
Patent Office

Office européen
des brevets

# EUROPEAN SEARCH REPORT

Application Number

EP 17 15 1644

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | OGAWA MIZUHITO ET AL: "SAT and SMT: Their Algorithm Designs and Applications", 2013 20TH ASIA-PACIFIC SOFTWARE ENGINEERING CONFERENCE (APSEC), IEEE, 2 December 2013 (2013-12-02), pages 83-84, XP032573613, ISSN: 1530-1362, DOI: 10.1109/APSEC.2013.118 [retrieved on 2014-03-03] * the whole document * | 1-9 | INV. G06F11/36 |
| X | SAFAR MONA ET AL: "Solving constraints in FPGA detailed routing using SMT", 2015 IEEE INTERNATIONAL CONFERENCE ON ELECTRONICS, CIRCUITS, AND SYSTEMS (ICECS), IEEE, 6 December 2015 (2015-12-06), pages 613-616, XP032884872, DOI: 10.1109/ICECS.2015.7440391 [retrieved on 2016-03-23] * the whole document * | 1-9 | |
| X | US 7 992 113 B1 (GOLDBERG EUGENE [US]) 2 August 2011 (2011-08-02) * column 5, line 5 - column 9, line 49 * | 1-9 | TECHNICAL FIELDS SEARCHED (IPC) G06F |

The present search report has been drawn up for all claims

| Place of search | Date of completion of the search | Examiner |
|---|---|---|
| The Hague | 24 May 2017 | Renault, Sophie |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

                             
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 17 15 1644

This annex lists the patent family members relating to the patent documents cited in the above-mentioned European search report.
The members are as contained in the European Patent Office EDP file on
The European Patent Office is in no way liable for these particulars which are merely given for the purpose of information.

24-05-2017

| Patent document cited in search report | Publication date | Patent family member(s) | Publication date |
|---|---|---|---|
| US 7992113 B1 | 02-08-2011 | NONE | |

For more details about this annex : see Official Journal of the European Patent Office, No. 12/82